Europäisches Patentamt

European Patent Office

Office européen des brevets

(19)

(11) **EP 0 588 111 B1**

(12) **EUROPÄISCHE PATENTSCHRIFT**

(45) Veröffentlichungstag und Bekanntmachung des Hinweises auf die Patenterteilung:
**03.12.1997 Patentblatt 1997/49**

(51) Int Cl.⁶: **G11C 11/411**, G11C 7/00, G11C 11/416

(21) Anmeldenummer: **93113494.4**

(22) Anmeldetag: **24.08.1993**

(54) **Speicherelement**

Memory element

Elément de mémoire

(84) Benannte Vertragsstaaten:
**DE FR GB IT**

(30) Priorität: **17.09.1992 DE 4231178**

(43) Veröffentlichungstag der Anmeldung:
**23.03.1994 Patentblatt 1994/12**

(73) Patentinhaber: **SIEMENS AKTIENGESELLSCHAFT**
**80333 München (DE)**

(72) Erfinder: **Delker, Klaus, Ing. grad.**
**D-81476 München (DE)**

(56) Entgegenhaltungen:
**EP-A- 0 257 938      WO-A-91/15855**
**US-A- 3 801 967**

**Beschreibung**

Die Erfindung betrifft ein Speicherelement mit den Merkmalen:

(a) die Emitter eines ersten und eines zweiten Transistors eines ersten Transistorpaares sind gekoppelt und über eine Stromquelle mit einem Anschluß für ein erstes Versorgungspotential verbunden,
(b) der Kollektor des ersten Transistors des ersten Transistorpaares ist mit den gekoppelten Emittern eines ersten und zweiten Transistors eines zweiten Transistorpaares verbunden,
(c) der Kollektor des zweiten Transistors des ersten Transistorpaares ist mit den gekoppelten Emittern eines ersten und eines zweiten Transistors eines dritten Transistorpaares verbunden,
(d) die Kollektoren der Transistoren des zweiten und dritten Transistorpaares sind paarweise gekoppelt und jeweils mit einem ersten Anschluß eines Widerstandes verbunden,
(e) ein zweiter Anschluß jedes Widerstandes ist jeweils über die Kollektor-Emitter-Strecke eines Transistors, eines weiteren Transistorpaares mit einem zweiten Versorgungspotential verbunden,
(f) die Transistoren des vierten Transistorpaares sind bezüglich des zweiten Versorgungspotentials in Emitterfolgerschaltung geschaltet,
(g) der Kollektor mindestens eines der Transistoren des vierten Transistorpaares ist mit einem Ausgangssignalanschluß und über einen Widerstand mit einem Anschluß für das zweite Versorgungspotential verbunden,
(h) die Basis des ersten Transistors des dritten Transistorpaares ist mit dem Kollektor des zweiten Transistors des dritten Transistorpaares verbunden,
(i) die Basisanschlüsse der ersten Transistoren des ersten und zweiten Transistorpaares sind Anschlüsse für je ein Eingangssignal,
(j) die Basisanschlüsse der zweiten Transistoren des ersten, zweiten und dritten Transistorpaares sind Anschlüsse für je ein Referenzsignal.

Solche Speicherelemente werden vorzugsweise in digitalen Schaltungen verwendet, die bei hoher Taktfrequenz arbeiten. Die höchste mögliche Arbeitsgeschwindigkeit des Speicherelementes wird im wesentlichen durch die kapazitive Last bestimmt, die an den paarweise gekoppelten Kollektoren der Transistoren des zweiten und dritten Transistorpaares anliegt. Diese Kapazitäten setzen sich hauptsächlich aus der Kapazität zwischen Metallisierung und Substrat der Verbindungsleitungen, mit denen die an diese Schaltungsknoten angeschlossenen Bauelemente verbunden sind, und der Kapazität zwischen den Kollektoren und dem Substrat der angeschlossenen Transistoren zusammen.

Bisher wurde zum Setzen und Rücksetzen des Speicherelements je ein Transistor verwendet, dessen Kollektor-Emitter-Strecke zwischen den Basisanschluß eines der Transistoren des dritten Transistorpaares und den gekoppelten Emitteranschlüssen dieser Transistoren geschaltet ist. Da der Basisanschluß eines jeden Transistors des dritten Transistorpaares über Kreuz mit dem Kollektoranschluß des jeweils anderen Transistors verbunden ist, wird durch einen zusätzlichen Transistor zum Setzen bzw. Rücksetzen des Speicherelementes die kapazitive Last an den Kollektoren der Transistoren des dritten Transistorpaares noch weiter erhöht. Somit wird die maximal erreichbare Arbeitsgeschwindigkeit verringert.

Die Aufgabe der Erfindung ist es, ein Speicherelement mit einer Setz- oder Rücksetzfunktion anzugeben, durch die die Schaltgeschwindigkeit des Speicherelements nicht beeinflußt wird.

Diese Aufgabe wird dadurch gelöst, daß

(k) die Emitter eines ersten und zweiten Transistors eines fünften Transistorpaares gekoppelt sind und über eine Stromquelle mit dem Anschluß für das erste Versorgungspotential verbunden sind,
(l) der Kollektor des ersten Transistors des fünften Transistorpaares mit der Basis eines der Transistoren des vierten Transistorpaares verbunden ist,
(m) der Kollektor des zweiten Transistors des fünften Transistorpaares mit dem Anschluß für das zweite Versorgungspotential verbunden ist,
(n) die Basis eines der Transistoren des fünften Transistorpaares ein Anschluß für ein Eingangssignal und die Basis eines anderen der Transistoren des fünften Transistorpaares ein Anschluß für ein Referenzsignal ist.

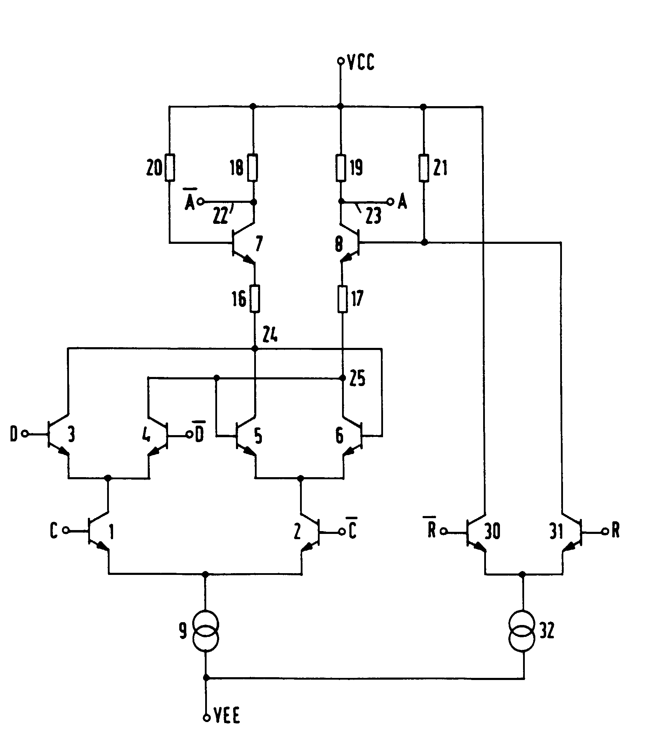

Die Erfindung wird im folgenden anhand der einzigen in der Zeichnung dargestellten Figur erläutert.

Das erfindungsgemäße Speicherelement enthält ein erstes Transistorpaar mit den Bipolartransistoren 1, 2, deren Emitter miteinander verbunden sind und über eine Stromquelle 9 mit einem Anschluß für ein erstes Versorgungspotential VEE verbunden sind. Mit den Kollektoren der Transistoren 1, 2 sind die gekoppelten Emitter jeweils eines weiteren Transistorpaares aus den Transistoren 3, 4 bzw. 5, 6 verbunden. Die Kollektoren der Transistoren der weiteren Transistorpaare sind paarweise gekoppelt. Wie in der Figur dargestellt, sind die Kollektoren der Transistoren 3, 5 zu einem Knoten 24 und die Kollektoren der Transistoren 4, 6 zu einem Knoten 25 verbunden. Die Knoten 24, 25 sind jeweils über die Reinenschaltung eines Widerstandes 16 bzw. 17 und die Kollektor-Emitter-Strecke eines Transistors 7 bzw. 8 mit einem Anschluß für ein zweites Versorgungspotential VCC verbunden. In den Kollektorkreis der Transistoren 7, 8 ist je ein Widerstand 18 bzw. 19 geschaltet. Die kollektorseitigen Anschlüsse der Widerstände 18, 19 weisen je einen Anschluß 22 bzw. 23 für ein Ausgangssignal A bzw. A auf. Die Basisanschlüsse der Transistoren 7, 8 werden über je einen Widerstand 20 bzw. 21, die mit dem Anschluß für das Versorgungspotential VCC verbunden sind, leitend gesteuert. Die Basisanschlüsse der Transistoren 1, 2 sind Anschlüsse für komplementäre Signale C bzw. C̅. Das Signal C ist üblicherweise das Taktsignal des Speicherelements. Die Basisanschlüsse der Transistoren 3, 4 sind Anschlüsse für zueinander komplementäre Datensignale D bzw. D̅. Die Basisanschlüsse der Transistoren 5, 6 sind jeweils über Kreuz auf die Kollektoren dieser Transistoren, also die Schaltungsknoten 25 bzw. 24 rückgekoppelt.

Als Einrichtung zum Rücksetzen des Speicherelementes ist ein Stromschalter aus Transistoren 30, 31 vorgesehen, deren gekoppelte Emitter über eine Stromquelle 32 mit dem Anschluß für das Versorgungspotential VEE verbunden sind. Der Kollektor des Transistors 30 ist mit dem Anschluß für das Versorgungspotential VCC verbunden, der Kollektor des Transistors 31 mit der Basis des Transistors 8. Die Basisanschlüsse der Transistoren 31, 30 werden von komplementären Rücksetz-Signalen R bzw. R̅ gesteuert.

Die Funktionsweise des Speicherelementes wird im folgenden erläutert. Während einer H-Phase des Taktsignals C ist der Transistor 1 leitend, der Transistor 2 gesperrt. Wenn das Datensignal D beispielsweise H ist, ist der Transistor 3 leitend, der Transistor 4 gesperrt. Der von der Stromquelle 9 eingeprägte Strom fließt dann über den Pfad der Transistoren 3, 1 und über den Pfad der Widerstände 16, 18 und des Transistors 7. Der Widerstand 18 ist derart dimensioniert, daß der Pegel des Ausgangssignals A̅ am Ausgang 22 ein L-Pegel ist. Der Widerstand 19 ist stromlos, so daß das Ausgangssignal A am Ausgang 23 H ist. Das Ausgangssignal A̅ ist also komplementär zum Datensignal D, das Ausgangssignal A dazu gleichsinnig. Wenn das Taktsignal C auf L umschaltet, fließt der Strom der Stromquelle 9 durch den Transistor 2 und den Stromschalter der Transistoren 5, 6. Aufgrund der gekreuzten Rückkopplung der Basisanschlüsse der Transistoren 5, 6 auf ihre entsprechenden Kollektor-Anschlüsse wird der Transistor 5 leitend, der Transistor 6 gesperrt. Die Pegel A, A̅ werden gespeichert und sind nun vom Datensignal D nicht mehr beeinflußbar.

Die Transistoren 7, 8 sind bezüglich des Versorgungspotentials VCC in Emitterfolgerschaltung geschaltet. Das Potential an den Emittern der Transistoren 7, 8 ist folglich konstant und setzt sich aus dem Spannungsabfall an den Widerständen 20 bzw. 21 und den Basis-Emitter-Spannungen der Transistoren 7 bzw. 8 zusammen. Durch die Transistoren 7, 8 werden die Signale A bzw. A̅ von den entsprechenden Signalen an den Schaltungsknoten 25 bzw. 24 entkoppelt. Durch das induktive Verhalten der Transistoren 7, 8 bezüglich der Signale an den Knoten 24 bzw. 25 werden die parasitären kapazitiven Lasten an diesen Schaltungsknoten kompensiert. Der Wert der Induktivität der Transistoren 7, 8 ist über die Widerstände 20 bzw. 21 einstellbar.

Das Rücksetzsignal R sei vorerst L. Der Transistor 31 ist dann gesperrt, so daß das Basispotential des Transistors 8 dadurch unbeeinflußt ist und der Schaltzustand des Speicherelementes erhalten bleibt. Nun wird das Rücksetzsignal R auf H gesetzt. Der Transistor 31 ist leitend, der Transistor 30 gesperrt. Dadurch wird das Potential an der Basis des Transistors 8 abgesenkt, so daß - das Taktsignal C ist L - der Stromschalter der Transistoren 5, 6 umschaltet. Der Transistor 5 wird aufgrund seines nunmehr niedrigen Basispotentials gesperrt, der Transistor 6 leitet. Das Ausgangssignal A schaltet auf L um. Das Speicherelement wird also durch einen H-Pegel des Rücksetzsignals R rückgesetzt.

Um das Speicherelement mit einer Setzfunktion zu versehen, ist ein Stromschalter, entsprechend dem Stromschalter aus den Transistoren 30, 31 und der Stromquelle 32 notwendig, bei dem der Kollektoranschluß eines der Transistoren mit dem Basisanschluß des Transistors 7 verbunden ist. Wenn dieser Transistor leitend gesteuert ist, wird das Basispotential des Transistors 7 soweit abgesenkt, daß der Transistor 6 gesperrt und der Transistor 5 leitend ist. Das Ausgangssignal A ist dann H. Soll das Speicherelement eine Setz- und Rücksetzfunktion haben, ist je ein Stromschalter für die Setz- und Rücksetzfunktion notwendig. Diese Stromschalter werden entsprechend den obigen Ausführungen angeschlossen.

Der erfindungsgemäße Stromschalter hat den Vorteil, daß die Knoten 24, 25 nicht zusätzlich kapazitiv belastet werden. Die für eine Setz- bzw. Rücksetzfunktion benötigten zusätzlichen Schaltungsmaßnahmen haben, wenn sie nicht aktiv sind, keinen Einfluß auf die Signalpfade im Speicherelement. Die Verzögerungszeit des Speicherelements und somit seine maximale Arbeitsgeschwindigkeit bleiben demnach unbeeinflußt.

Für ein erfindungsgemäßes Speicherelement sind weitere, nicht in der Zeichnung dargestellte Ausführungsformen möglich. Die Eingänge des in der Zeichnung dargestellten Speicherelements werden von komplementären Signalen gesteuert. In entsprechender Weise weisen die Ausgangssignalanschlüsse komplementäre Signale auf. Es ist auch möglich, nur einen der Arbeitswiderstände 18 oder 19 und nur einen der entsprechenden Ausgangssignalanschlüsse 22 bzw. 23 zu verwenden. Der Kollektor einer der Transistoren 7, 8 ist dann unmittelbar mit dem Anschluß für das Versorgungspotential VCC verbunden.

Weiterhin ist es möglich, als Referenzsignale für die Signale D, C, R anstelle der komplementären Signale D̅, C̅, R̅ feste Referenzpotentiale zu verwenden. Die Referenzpotentiale liegen vorzugsweise in der Mitte des Signalpegelhubs der entsprechenden Signale D, C bzw. R.

Es ist auch denkbar, die Basis nur eines der Transistoren 5, 6 mit dem Knoten 25 bzw. 24 zu verbinden. Die Basis des jeweils anderen der Transistoren 5, 6 wird dann von einem Referenzpotential gesteuert. Der Wert dieses Referenzpotentials liegt vorzugsweise in der Mitte des an der Basis des einen der Transistoren anliegenden Pegelhubs. Üblicherweise ist die Schaltung so dimensioniert, daß diese Pegel den Pegelwerten für L und H des Signals D entsprechen.

## Patentansprüche

1.  Speicherelement mit den Merkmalen:

    (a) die Emitter eines ersten und eines zweiten Transistors (1, 2) eines ersten Transistorpaares sind gekoppelt und über eine Stromquelle (9) mit einem Anschluß für ein erstes Versorgungspotential (VEE) verbunden,
    (b) der Kollektor des ersten Transistors (1) des ersten Transistorpaares ist mit den gekoppelten Emittern eines ersten und zweiten Transistors (3, 4) eines zweiten Transistorpaares verbunden,
    (c) der Kollektor des zweiten Transistors (2) des ersten Transistorpaares ist mit den gekoppelten Emittern eines ersten und eines zweiten Transistors (5, 6) eines dritten Transistorpaares verbunden,
    (d) die Kollektoren der Transistoren des zweiten und dritten Transistorpaares (3, 5; 4, 6) sind paarweise gekoppelt und jeweils mit einem ersten Anschluß eines Widerstandes (16, 17) verbunden,
    (e) ein zweiter Anschluß jedes Widerstandes (16, 17) ist jeweils über die Kollektor-Emitter-Strecke eines Transistors eines vierten Transistorpaares (7, 8) mit einem zweiten Versorgungspotential (VCC) verbunden,
    (f) die Transistoren des vierten Transistorpaares (7, 8) sind bezüglich des zweiten Versorgungspotentials (VCC) in Emitterfolgerschaltung geschaltet,
    (g) der Kollektor mindestens eines der Transistoren des vierten Transistorpaares (7, 8) ist mit einem Ausgangssignalanschluß (22, 23) und über einen Widerstand (18, 19) mit einem Anschluß für das zweite Versorgungspotential (VCC) verbunden,
    (h) die Basis des ersten Transistors (5) des dritten Transistorpaares ist mit dem Kollektor des zweiten Transistors (6) des dritten Transistorpaares verbunden,
    (i) die Basisanschlüsse der ersten Transistoren (1, 3) des ersten und zweiten Transistorpaares sind Anschlüsse für je ein Eingangssignal (C, D),
    (j) die Basisanschlüsse der zweiten Transistoren (2, 4, 6) des ersten, zweiten und dritten Transistorpaares sind Anschlüsse für je ein Referenzsignal,

**dadurch gekennzeichnet,** daß

    (k) die Emitter eines ersten und zweiten Transistors (30, 31) eines fünften Transistorpaares gekoppelt sind und über eine Stromquelle (32) mit dem Anschluß für das erste Versorgungspotential (VEE) verbunden sind,
    (l) der Kollektor des ersten Transistors (31) des fünften Transistorpaares mit der Basis eines der Transistoren (8) des vierten Transistorpaares (7, 8) verbunden ist,
    (m) der Kollektor des zweiten Transistors (30) des fünften Transistorpaares mit dem Anschluß für das zweite Versorgungspotential (VCC) verbunden ist,
    (n) die Basis eines der Transistoren des fünften Transistorpaares (31) ein Anschluß für ein Eingangssignal (R) und die Basis eines anderen der Transistoren (30) des fünften Transistorpaares ein Anschluß für ein Referenzsignal ($\overline{R}$) ist.

2.  Speicherelement nach Anspruch 1, **dadurch gekennzeichnet,** daß die Referenzsignale feste Potentiale sind.

3.  Speicherelement nach Anspruch 1, **dadurch gekennzeichnet,** daß die Referenzsignale der zweiten Transistoren (2, 4) des ersten und zweiten Transistorpaares die komplementären Eingangssignale ($\overline{C}$, $\overline{D}$) der Basisanschlüsse der ersten Transistoren (1, 3) des ersten und zweiten Transistorpaares sind.

4.  Speicherelement nach Anspruch 3, **dadurch gekennzeichnet,** daß die Basis des zweiten Transistors (6) des dritten Transistorpaares mit dem Kollektor des ersten Transistors (5) des dritten Transistorpaares verbunden ist.

5.  Speicherelement nach Anspruch 1, **dadurch gekennzeichnet,** daß das Referenzsignal des fünften Transistorpaares das zum Eingangssignal (R) des fünften Transistorpaares komplementäre Signal (R) ist.

## Claims

1.  Memory element having the features:

    (a) the emitters of a first and of a second transistor (1, 2) of a first transistor pair are coupled and are connected via a current source (9) to a terminal for a first supply potential (VEE),
    (b) the collector of the first transistor (1) of the first transistor pair is connected to the coupled emitters of a first and second transistor (3, 4) of a second transistor pair,

(c) the collector of the second transistor (2) of the first transistor pair is connected to the coupled emitters of a first and of a second transistor (5, 6) of a third transistor pair,

(d) the collectors of the transistors of the second and third transistor pairs (3, 5; 4, 6) are coupled in pairs and are respectively connected to a first terminal of a resistor (16, 17),

(e) a second terminal of each resistor (16, 17) is respectively connected to a second supply potential (VCC), via the collector-emitter path of a transistor of a fourth transistor pair (7, 8),

(f) the transistors of the fourth transistor pair (7, 8) are connected in an emitter follower circuit with regard to the second supply potential (VCC),

(g) the collector of at least one of the transistors of the fourth transistor pair (7, 8), is connected to an output signal terminal (22, 23) and, via a resistor (18, 19), to a terminal for the second supply potential (VCC),

(h) the base of the first transistor (5) of the third transistor pair is connected to the collector of the second transistor (6) of the third transistor pair,

(i) the base terminals of the first transistors (1, 3) of the first and second transistor pairs are terminals for a respective input signal (C, D),

(j) the base terminals of the second transistors (2, 4, 6) of the first, second and third transistor pairs are terminals for a respective reference signal,

characterized in that

(k) the emitters of a first and second transistor (30, 31) of a fifth transistor pair are coupled and are connected via a current source (32) to the terminal of the first supply potential (VEE),

(l) the collector of the first transistor (31) of the fifth transistor pair is connected to the base of one of the transistors (8) of the fourth transistor pair (7, 8),

(m) the collector of the second transistor (30) of the fifth transistor pair is connected to the terminal for the second supply potential (VCC),

(n) the base of one of the transistors of the fifth transistor pair (31) is a terminal for an input signal (R) and the base of another of the transistors (30) of the fifth transistor pair is a terminal for a reference signal ($\overline{R}$).

2. Memory element according to Claim 1, characterized in that the reference signals are fixed potentials.

3. Memory element according to Claim 1, characterized in that the reference signals of the second transistors (2, 4) of the first and second transistor pairs are the complementary input signals ($\overline{C}$, $\overline{D}$) of the base terminals of the first transistors (1, 3) of the first and second transistor pairs.

4. Memory element according to Claim 3, characterized in that the base of the second transistor (6) of the third transistor pair is connected to the collector of the first transistor (5) of the third transistor pair.

5. Memory element according to Claim 1, characterized in that the reference signal of the fifth transistor pair is the signal ($\overline{R}$) which is complementary to the input signal (R) of the fifth transistor pair.

**Revendications**

1. Elément de mémoire ayant les caractéristiques suivantes :

(a) les émetteurs d'un premier et d'un deuxième transistor (1, 2) d'une première paire de transistors sont couplés et reliés par une source de courant (9) à une borne d'un premier potentiel d'alimentation (VEE),

(b) le collecteur du premier transistor (1) de la première paire de transistors est relié aux émetteurs couplés d'un premier et deuxième transistor (3, 4) d'une deuxième paire de transistors,

(c) le collecteur du deuxième transistor (2) de la première paire de transistors est relié aux émetteurs couplés d'un premier et d'un deuxième transistor (5, 6) d'une troisième paire de transistors,

(d) les collecteurs des transistors de la deuxième et troisième paire de transistors (3, 5 ; 4, 6) sont couplés par paire et reliés chacun à une première borne d'une résistance (16, 17),

(e) une deuxième borne de chaque résistance (16, 17) est reliée à chaque fois par la ligne collecteur-émetteur d'un transistor d'une quatrième paire de transistors (7, 8) à un deuxième potentiel d'alimentation (VCC),

(f) les transistors de la quatrième paire de transistors (7, 8) sont mis en circuit émetteur-suiveur par rapport au deuxième potentiel d'alimentation (VCC)

(g) le collecteur d'un au moins des transistors de la quatrième paire de transistors (7, 8) est relié à une borne de signal de sortie (22, 23) et, par une résistance (18, 19), à une borne du deuxième potentiel d'alimentation (VCC),

(h) la base du premier transistor (5) de la troisième paire de transistors est reliée au collecteur du deuxième transistor (6) de la troisième paire de transistors,

(i) les bornes de base des premiers transistors (1, 3) de la première et deuxième paire de transistors sont les bornes de respectivement un signal d'entrée (C, D),

(j) les bornes de base des deuxièmes transistors (2, 4, 6) de la première, deuxième et troisième paire de transistors sont les bornes de respectivement un signal de référence,

caractérisé en ce que

(k) les émetteurs d'un premier et deuxième transistor (30, 31) d'une cinquième paire de transistors sont couplés et reliés par une source de courant (32) à la borne du premier potentiel d'alimentation (VEE),

(l) le collecteur du premier transistor (31) de la cinquième paire de transistors est relié à la base d'un des transistors (8) de la quatrième paire de transistors (7, 8),

(m) le collecteur du deuxième transistor (30) de la cinquième paire de transistors est relié à la borne du deuxième potentiel d'alimentation (VCC),

(n) la base d'un des transistors de la cinquième paire de transistors (31) est une borne d'un signal d'entrée (R) et la base d'un autre des transistors (30) de la cinquième paire de transistors une borne d'un signal de référence (R).

2. Elément de mémoire selon la revendication 1, caractérisé en ce que les signaux de référence sont des potentiels constants.

3. Elément de mémoire selon la revendication 1, caractérisé en ce que les signaux de référence des deuxièmes transistors (2, 4) de la première et deuxième paire de transistors sont les signaux d'entrée ($\overline{C}$, $\overline{D}$) complémentaires des bornes de base des premiers transistors (1, 3) de la première et deuxième paire de transistors.

4. Elément de mémoire selon la revendication 3, caractérisé en ce que la base du deuxième transistor (6) de la troisième paire de transistors est reliée au collecteur du premier transistor (5) de la troisième paire de transistors.

5. Elément de mémoire selon la revendication 1, caractérisé en ce que le signal de référence de la cinquième paire de transistors est le signal (P) complémentaire du signal d'entrée (R) de la cinquième paire de transistors.